# EUROPEAN PATENT APPLICATION

(11) **EP 4 738 605 A1**
(43) Date of publication of application: **06.05.2026**
(21) Application number: 24902250.0
(22) Date of filing: 13.09.2024
(51) Int. Cl.: H01Q 1/38

(54) **ELECTRONIC DEVICE**

(30) Priority: 13.12.2023 CN 202311710584
(71) Applicant: Huawei Technologies Co., Ltd., Shenzhen, Guangdong 518129 (CN)
(72) Inventor: LU, Liang, Shenzhen, Guangdong 518129 (CN); ZHANG, Jinglei, Shenzhen, Guangdong 518129 (CN); ZHANG, Yun, Shenzhen, Guangdong 518129 (CN)
(74) Representative: Gill Jennings & Every LLP
(86) International application number: PCT/CN2024/118742
(87) International publication number: WO 2025/123824

(57) **Abstract**

An electronic device includes a housing, a feed network, and a circuit board. The housing is provided with an accommodation cavity, and a feed post and a ground post are integrally formed in the accommodation cavity. The feed network is connected to the feed post, and is configured to feed the accommodation cavity. A ground terminal of the circuit board is connected to the ground post, and is configured to discharge static electricity on the accommodation cavity. In this application, at least a part of an area of the accommodation cavity on the electronic device is reused as a radiator, so that occupied space in the electronic device can be greatly reduced, and good antenna efficiency can be obtained. During processing and manufacturing, the feed post and the ground post are integrally formed in the accommodation cavity, thereby ensuring structural continuity, and avoiding impact on distribution of antenna resonance caused by generation of a connection gap between the accommodation cavity, the feed post, and the ground post. In addition, the ground post in the accommodation cavity is connected to the ground terminal on the circuit board, so that static electricity on the accommodation cavity can be conducted to the ground terminal on the circuit board in time through the ground post for discharge.

## Description

The present invention claims priority to Chinese Patent Application No. 202311710584.7, filed with the China National Intellectual Property Administration on December 13, 2023 and entitled "ELECTRONIC DEVICE", which is incorporated herein by reference in its entirety.

### TECHNICAL FIELD

This application relates to the field of communication technologies, and in particular, to an electronic device.

### BACKGROUND

An antenna is an apparatus for receiving and sending an electromagnetic wave, and is widely used in electronic products such as mobile phones. Antennas covering different operating frequency bands have different sizes. For example, an L5 antenna has a lower frequency, a longer wavelength, and a smaller free space attenuation than an L1 antenna. However, in a mobile phone with compact internal space, the L5 antenna is large in size, and it is difficult to design an L5 antenna with good performance in limited space.

### SUMMARY

In view of this, this application provides an electronic device, to design an L5 antenna with good performance in limited space of the electronic device.

An embodiment of this application provides an electronic device, including a housing, a feed network, and a circuit board. The housing is provided with an accommodation cavity, at least a part of the accommodation cavity is provided with a metal layer, a feed post and a ground post are integrally formed in the accommodation cavity, and the feed post and the ground post are electrically connected to the metal layer. The feed network is connected to the feed post, and is configured to feed power to the metal layer through the feed post. A ground terminal of the circuit board is electrically connected to the ground post, and is configured to discharge static electricity on the metal layer.

In this application, the metal layer of the accommodation cavity in the electronic device is reused as a radiator, so that occupied space in the electronic device can be greatly reduced. That is, an L5 antenna can be designed in limited space of the electronic device. In addition, the L5 antenna formed by reusing the metal layer of the accommodation cavity is an independent antenna, and does not need to share a radiator with another antenna. The L5 antenna can obtain good antenna efficiency and has better radiation performance. During processing and manufacturing, the feed post and the ground post may be integrally formed in the accommodation cavity, so that the accommodation cavity including the feed post and the ground post forms an overall structure, thereby ensuring structural continuity, and avoiding impact on distribution of antenna resonance caused by generation of a connection gap at a position at which the accommodation cavity, the feed post, and the ground post are electrically connected to each other. This facilitates configuration of an antenna with expected performance, to achieve expected radiation effect. In addition, the accommodation cavity, the feed post, and the ground post are integrally formed, to implement miniaturization of an antenna structure, ensure reliability of the structure, and facilitate assembly of the structure to the housing 1. In addition, the ground post connected to the metal layer is connected to the ground terminal of the circuit board, so that static electricity on the metal layer can be conducted to the ground terminal of the circuit board in time through the ground post for discharge, to ensure normal operation of a camera module and improve user experience.

In a possible design, the electronic device further includes a first matching circuit, and the ground post is electrically connected to the ground terminal by using the first matching circuit. The first matching circuit is a circuit related to adjusting a radiation characteristic of an antenna. In an embodiment, the first matching circuit has a function of impedance matching and/or frequency tuning. In this application, more importantly, the first matching circuit may improve effect of discharging static electricity to the ground through matching impedance.

In a possible design, the first matching circuit includes a first metal part. One end of the first metal part is connected to the ground post, and the other end of the first metal part is electrically connected to the ground terminal. The first metal part may be equivalent to an inductor element, so that both an electrostatic discharge requirement and an antenna performance requirement can be met.

In a possible design, the first metal part includes a first connection segment, a second connection segment, and an extension segment. Two ends of the extension segment are respectively connected to a first end of the first connection segment and a first end of the second connection segment, so that the first metal part is C-shaped, a second end of the first connection segment is connected to the ground post, and a second end of the second connection segment is connected to the ground terminal. The first metal part having this structure may occupy small space, and may have a large physical length between the first ground post and the ground terminal, so that an inductor that meets the antenna performance requirement and the electrostatic discharge requirement can be configured.

In a possible design, the first matching circuit includes a capacitor and/or an inductor and/or a radio frequency switch. A specific circuit configuration form of the first matching circuit may be designed according to the antenna performance requirement and the electrostatic discharge requirement, so that flexibility of an antenna design may be high.

In a possible design, the electronic device further includes a second matching circuit, and the feed post is connected to the feed network by using the second matching circuit. The second matching circuit is a circuit related to adjusting the radiation characteristic of the antenna. In an embodiment, the second matching circuit may have a function similar to that of the first matching circuit. That is, the second matching circuit has the function of impedance matching and/or frequency tuning.

In a possible design, the second matching circuit includes a second metal part. One end of the second metal part is connected to the feed post, and the other end of the second metal part is connected to the feed network. In a direction perpendicular to a thickness direction of the electronic device, an integrally formed metal sheet has a specific length size. In a case in which the feed post and the feed network are difficult to be directly and effectively connected due to a long distance between the feed post and the feed network, the metal sheet may be used for transfer. This facilitates more flexible design of positions of the feed post and the feed network, and can meet structural layout requirements of different electronic devices.

In a possible design, the second matching circuit includes a capacitor and/or an inductor and/or a radio frequency switch. The second matching circuit may have a structure form similar to that of the first matching circuit. Specifically, the capacitor, the inductor, or the radio frequency switch may be configured based on feeding and radiation requirements of the antenna. For example, the capacitor or the inductor may be separately configured. Alternatively, both the capacitor and the inductor may be configured, and are connected in series or in parallel. Alternatively, the radio frequency switch may be used. The radio frequency switch may include a plurality of branches. Each branch may be configured with a capacitor or an inductor, which can be switched through the switch to connect to a circuit. This is not specifically limited in this embodiment, so that flexibility of an antenna design may be high.

In a possible design, a plurality of ground posts are disposed and spaced from each other. The plurality of ground posts may be distributed at different positions on the metal layer, so that static electricity at different positions on the metal layer can be discharged. In some embodiments, a position of the ground post may be specifically set based on electrostatic distribution on the metal layer.

In a possible design, the ground post includes a first ground post and a second ground post. A distance between the first ground post and the feed post is less than a distance between the second ground post and the feed post. An equivalent inductance of the first ground post is greater than an equivalent inductance of the second ground post. Static electricity distributed near the feed post is strong. Therefore, a strength of static electricity distributed near the first ground post is greater than a strength of static electricity distributed near the second ground post, and an area with a stronger electrostatic distribution indicates a need for a larger equivalent inductance of the ground post. In this way, static electricity with strong strength can be effectively conducted to the ground through the ground post, thereby implementing effective electrostatic discharge. Therefore, in this embodiment of this application, the equivalent inductance of the first ground post is greater than the equivalent inductance of the second ground post, so that static electricity in an area with concentrated static electricity can be effectively discharged to the ground, thereby ensuring normal operation of the camera module.

In a possible design, an equivalent inductance of the first matching circuit is less than 30 nH, and an equivalent inductance of the second matching circuit is less than 5 nH. When the equivalent inductances of the first ground post and the second ground post meet the foregoing range, for most electronic devices, static electricity on a metal layer of an accommodation cavity such as a metal camera decorative part can be discharged as required.

In a possible design, the end of the first metal part is electrically connected to the first ground post. The first metal part may be equivalent to an inductor element, so that the antenna performance requirement is met, and the electrostatic discharge requirement can be met through cooperation between the first metal part and the first ground post.

In a possible design, the electronic device further includes a metal spring, and the second ground post is connected to the ground terminal by using the metal spring, so that connection reliability between the second ground post and the circuit board can be ensured, and effect of electrostatic discharge can be improved through cooperation between the metal spring and the second ground post.

In a possible design, the accommodation cavity includes a body and a flange, and the flange is circumferentially connected to an edge of the body. The flange is connected to the housing, and the body protrudes from a surface that is of the housing and that is away from the accommodation cavity. The metal layer is disposed on a surface that is of the body and that is close to the housing. The body and the flange may enclose space that can accommodate a device. For example, at least a part of the camera module may be accommodated in the space. In other words, in some embodiments, the accommodation cavity having the foregoing structure may form a metal camera decorative part, and can be used to protect and decorate the camera. At the metal camera decorative part, the electronic device has large space in the thickness direction. The space may be used for arrangement of structures such as the feed post and the ground post of the antenna, and no additional space needs to be developed in the electronic device, thereby facilitating design of an antenna with a large size in limited space of the electronic device.

In a possible design, the body is made of a metal material, and the metal layer is the surface that is of the body and that is close to the housing. That is, the whole body may act as a radiator to radiate energy. In addition, the flange may also be made of a metal material, and the flange and the body may be integrally formed, so that the accommodation cavity is formed into a metal cavity. Certainly, in some embodiments, the flange may alternatively be made of a non-metal material such as plastic.

In a possible design, the body is made of a plastic material, the metal layer is a metal sheet, and the metal sheet is fastened to the surface that is of the body and that is close to the housing. The metal layer may be a thin metal sheet with good conductivity, such as a copper sheet, and can be fastened to the body by using an SMT process. In some embodiments, the metal layer may alternatively be formed on the surface that is of the body and that is close to the housing by using a process such as electroplating. In addition, the flange and the body may alternatively use a same material, so that the body and the flange can be integrally formed, to facilitate processing and manufacturing.

In a possible design, the accommodation cavity is a metal camera decorative part, and the metal camera decorative part is provided with a camera opening. The metal camera decorative part can be used to protect and decorate a camera. At the metal camera decorative part, the electronic device has large space in the thickness direction. The space may be used for arrangement of structures such as the feed post and the ground post of the antenna, and no additional space needs to be developed in the electronic device, thereby facilitating design of an antenna with a large size in limited space of the electronic device.

In a possible design, a center frequency of a radio frequency signal fed by the feed network to the metal layer through the feed post is 1.17 GHz. In other words, the feed network may feed a radio frequency signal of an L5 frequency band (a center frequency is 1.17 GHz) to the accommodation cavity through the feed post, so that the metal layer forms a radiator of an L5 antenna. Therefore, the metal layer of the accommodation cavity in the electronic device is reused as a radiator, so that occupied space in the electronic device can be greatly reduced. That is, the L5 antenna can be designed in the limited space of the electronic device. In addition, the L5 antenna formed by reusing the metal layer of the accommodation cavity is an independent antenna, and does not need to share a radiator with another antenna. The L5 antenna can obtain good antenna efficiency and has better radiation performance.

It should be understood that the foregoing general descriptions and the following detailed descriptions are merely used as an example, and should not limit this application.

### BRIEF DESCRIPTION OF DRAWINGS

To describe the technical solutions in embodiments of this application more clearly, the following briefly describes the accompanying drawings used in embodiments. It is clear that the accompanying drawings in the following descriptions show merely some embodiments of this application, and a person of ordinary skill in the art may derive other drawings from these accompanying drawings without creative efforts.
FIG. 1 is a diagram of a structure of an electronic device according to an embodiment of this application;
FIG. 2 is a side view of an electronic device according to an embodiment of this application;
FIG. 3 is a partial sectional view of the electronic device in FIG. 2 at a position A;
FIG. 4 is a bottom view of an accommodation cavity according to an embodiment of this application;
FIG. 5 is a side view of an accommodation cavity according to an embodiment of this application;
FIG. 6 is a top view of a first metal part according to an embodiment of this application;
FIG. 7 is a schematic of a structure of a first matching circuit according to an embodiment of this application; and
FIG. 8 is a top view of a second matching circuit according to an embodiment of this application.

### Reference numerals:

1: housing;
2: accommodation cavity;
   21: body;
   22: flange;
   23: feed post;
   24: ground post;
      241: first ground post;
      242: second ground post;
   25: camera opening;
3: first matching circuit;
   31: first metal part;
   311: extension segment;
   312: first connection segment;
   313: second connection segment;
4: second matching circuit;
5: circuit board;
6: camera module.

### DESCRIPTION OF EMBODIMENTS

To better understand the technical solutions of this application, the following describes embodiments of this application in detail with reference to the accompanying drawings.

It should be noted that described embodiments are merely some rather than all of embodiments of this application. All other embodiments obtained by a person of ordinary skill in the art based on embodiments of this application without creative efforts shall fall within the protection scope of this application.

Terms used in embodiments of this application are merely for the purpose of illustrating specific embodiments, and are not intended to limit this application. The terms "a", "the" and "this" of singular forms used in embodiments and the appended claims of this application are also intended to include plural forms, unless otherwise specified in the context clearly.

It should be understood that the term "and/or" used in this specification describes only an association relationship between associated objects and represents that three relationships may exist. For example, A and/or B may represent the following three cases: Only A exists, both A and B exist, and only B exists. In addition, the character "/" in this specification usually indicates an "or" relationship between the associated objects.

In the descriptions of this application, unless otherwise specified and limited, the terms "first" and "second" are merely intended for a purpose of description, and cannot be understood as an indication or implication of relative importance. Unless otherwise specified or stated, the term "a plurality of" means two or more. The terms "connection", "fastening", and the like all should be understood in a broad sense. For example, the "connection" may be a fastened connection, or may be a detachable connection, an integrated connection, or an electrical connection; or may be a direct connection, or may be an indirect connection through an intermediate medium. A person of ordinary skill in the art may understand specific meanings of the foregoing terms in this application based on a specific case.

An antenna is an apparatus for receiving/sending an electromagnetic wave, and is widely used in electronic products such as mobile phones. Antennas covering different operating frequency bands have different sizes. For example, an L5 antenna (with a center frequency of 1.17 GHz) has a lower frequency, a longer wavelength, and a smaller free space attenuation than an L1 antenna (with a center frequency of 1.57 GHz), but a size of the L5 antenna is also larger. For a small electronic product such as a mobile phone, because the mobile phone has compact internal space, and the L5 antenna is large in size, it is difficult to design an L5 antenna with good performance in limited space. To arrange the L5 antenna in an electronic device, it is usually considered that the L5 antenna and another antenna are designed as a co-radiator antenna. For example, the L5 antenna and an MHB (1.7 GHz to 2.7 GHz) antenna may be designed in a co-radiator form. That is, the L5 antenna and the MHB antenna share a radiator, or the L5 antenna is used as a radiation stub of the MHB antenna. Although a length of the overall antenna in this design form can be reduced, an antenna efficiency of the L5 antenna is severely affected, and radiation performance of the antenna is reduced.

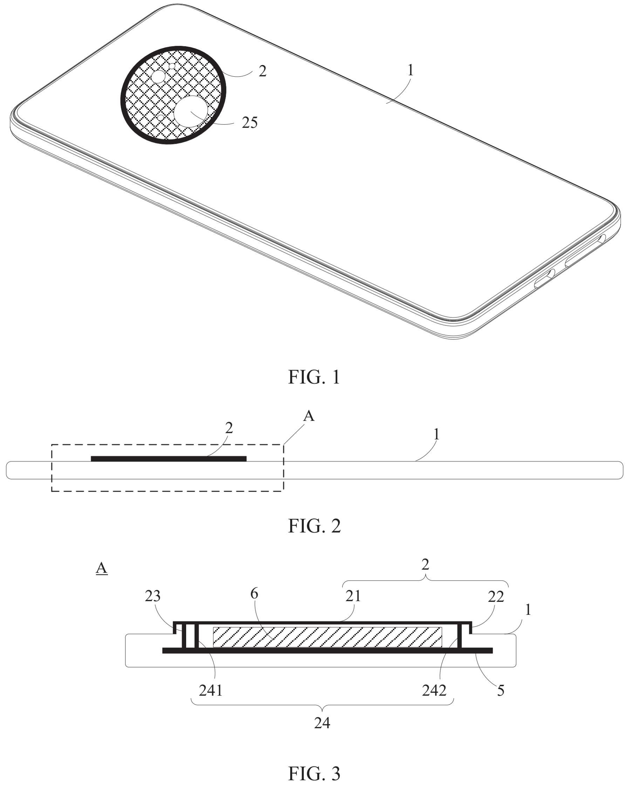

Therefore, an embodiment of this application provides an electronic device. The electronic device may be a mobile phone, a tablet computer, a notebook computer, a smart household, a smart band, a smart watch, a smart helmet, smart glasses, or the like. Alternatively, the electronic device may be a handheld device with a wireless communication function, a computing device or another processing device connected to a wireless modem, a vehicle-mounted device, an electronic device in a 5G network, an electronic device in a future evolved public land mobile network (public land mobile network, PLMN), or the like. This is not limited in embodiments of this application. FIG. 1 shows an example of an electronic device according to an embodiment of this application. An example in which the electronic device is a mobile phone is used for description.

FIG. 2 is a side view of an electronic device according to an embodiment of this application. FIG. 3 is a partial sectional view of the electronic device in FIG. 2 at a position A. Refer to FIG. 2 and FIG. 3. The electronic device provided in this embodiment of this application includes a housing 1, a feed network, and a circuit board 5. The housing 1 may be a housing part exposed on an outermost side of the electronic device, and can be directly touched by a user. For example, when the electronic device is a mobile phone, the housing 1 may be a structural part such as a battery cover or a rear cover. The housing 1 may be made of a metal material, or certainly may be made of a plastic material with specific hardness, and can protect and support a plurality of components in the electronic device.

Refer to FIG. 3. The housing 1 is provided with an accommodation cavity 2, and at least a part of the accommodation cavity 2 is provided with a metal layer. In some embodiments, the accommodation cavity 2 may be a non-closed cavity structure enclosed by a metal material, so that the accommodation cavity 2 forms a metal cavity, and the metal layer is at least a part of an inner surface of the accommodation cavity 2. In some embodiments, the accommodation cavity 2 may alternatively be a non-closed cavity structure enclosed by a non-metal material such as plastic, and the metal layer may be of a thin metal sheet structure, and may be fastened to at least a part of an inner surface of the accommodation cavity 2. The inner surface of the accommodation cavity 2 is a surface that is of the accommodation cavity 2 and that faces the housing 1. The accommodation cavity 2 may be a separately processed part, and can be assembled on the housing 1. Alternatively, the accommodation cavity 2 may be a structure integrally formed with the housing 1. For example, for an electronic device having a photographing function, the accommodation cavity 2 may be a metal camera decorative part mounted on the housing 1. The metal camera decorative part may protect and decorate a camera module 6. Usually, there is specific space in the metal camera decorative part, and at least a part of the camera module 6 can be accommodated in the space. The metal camera decorative part may be provided with a camera opening 25, and a camera in the camera module 6 may correspond to the camera opening 25, to facilitate photographing.

The metal layer of the accommodation cavity 2 may be used as a radiator of an antenna for receiving/sending an electromagnetic wave. Refer to FIG. 3. A feed post 23 and a ground post 24 may be integrally formed in the accommodation cavity 2. The feed post 23 is connected to the feed network. The feed network may include a power divider, a phase shifter, a coupler, a filter, and the like, to implement functions such as impedance matching, amplitude and phase control, and harmonic suppression. Power may be fed to the metal layer through the feed post 23. In this embodiment of this application, the feed network may feed a radio frequency signal of an L5 frequency band (a center frequency is 1.17 GHz) to the accommodation cavity 2 through the feed post 23, so that the metal layer of the accommodation cavity 2 forms a radiator of the L5 antenna. Therefore, the metal layer of the accommodation cavity 2 in the electronic device is reused as the radiator, so that occupied space in the electronic device can be greatly reduced. That is, the L5 antenna can be designed in limited space of the electronic device. In addition, the L5 antenna formed by reusing the metal layer of the accommodation cavity 2 is an independent antenna, and does not need to share a radiator with another antenna. The L5 antenna can obtain good antenna efficiency and has better radiation performance. In addition, the feed network may alternatively feed a radio frequency signal of another frequency band to the metal layer, so that the metal layer can form an antenna that can cover another operating frequency band. This is not limited in this embodiment.

During processing and manufacturing, the feed post 23 and the ground post 24 may be integrally formed in the accommodation cavity 2, so that the accommodation cavity 2 including the feed post 23 and the ground post 24 forms an overall structure, thereby ensuring structural continuity, and avoiding impact on distribution of antenna resonance caused by generation of a connection gap at a position at which the accommodation cavity 2, the feed post 23, and the ground post 24 are electrically connected to each other. This facilitates configuration of an antenna with expected performance, to achieve expected radiation effect. In addition, the accommodation cavity 2, the feed post 23, and the ground post 24 are integrally formed, to implement miniaturization of an antenna structure, ensure reliability of the structure, and facilitate assembly of the structure to the housing.

In some embodiments, as described above, the accommodation cavity 2 may be a metal camera decorative part, and the metal camera decorative part may be reused as the radiator. As a result, the metal camera decorative part generates a large amount of static electricity in some application scenarios, for example, in a dry environment and under friction-generated electricity. If static electricity cannot be discharged in time, severe damage is caused to the camera module 6, bringing discomfort to the user, and affecting user experience.

Therefore, refer to FIG. 3. A ground terminal of the circuit board 5 provided in this embodiment needs to be connected to the ground post 24, so that static electricity on the metal layer can be conducted to the ground terminal of the circuit board 5 in time through the ground post 24 for discharge, to ensure normal operation of the camera module 6 and improve user experience. In some embodiments, the circuit board 5 may be a printed circuit board (printed circuit board, PCB), for example, an 8-layer, 10-layer, or 12-layer to 14-layer board having 8, 10, 12, 13, or 14 layers of conductive materials, or an element that is separated by a dielectric layer or an insulation layer like glass fiber or polymer and that is electrically insulated. In an embodiment, the circuit board 5 includes a dielectric substrate, a ground layer, and a trace layer. The ground layer is the foregoing ground terminal, the ground layer may be specifically a grounding signal line arranged in the circuit board 5, and the trace layer is electrically connected to the ground layer through a via. In an embodiment, components such as a display, a touchscreen, an input button, a transmitter, a processor, a memory, a battery, a charging circuit, and a system on chip (system on chip, SoC) structure may be mounted on or connected to the circuit board 5, or electrically connected to the trace layer and/or the ground layer in the circuit board 5. For example, a radio frequency source is disposed at the trace layer. In some embodiments, the radio frequency source may be a radio frequency signal line, that is, an input or output signal line led out from the circuit board 5 through a chip port. The radio frequency signal line may be a signal line used for transmitting a radio frequency signal of an L5 frequency band, and can be electrically connected to the feed post 23.

In some embodiments, refer to FIG. 3. The accommodation cavity 2 may include a body 21 and a flange 22, and the flange 22 may be circumferentially around and connected to an edge of the body 21. In some embodiments, the flange 22 and the housing 1 may be connected by using a process such as welding, heat fusion, or the like, or may be integrally formed. One end that is of the flange 22 and that is away from the body 21 may be connected to the housing 1, and the body 21 protrudes from a surface of the housing 1. The metal layer may be disposed on a surface that is of the body 21 and that is close to the housing 1. The body 21 and the flange 22 may enclose space that can accommodate a device. For example, at least a part of the camera module 6 may be accommodated in the space. In other words, in some embodiments, the accommodation cavity 2 having the foregoing structure may form the metal camera decorative part, and can be used to protect and decorate the camera. At the metal camera decorative part, the electronic device has large space in a thickness direction. The space may be used for arrangement of structures such as the feed post 23 and the ground post 24 of the antenna, and no additional space needs to be developed in the electronic device, thereby facilitating design of an antenna with a large size in limited space of the electronic device.

In some embodiments, the body 21 may be made of a metal material, and the surface that is of the body 21 and that is close to the housing 1 may be the metal layer. That is, the whole body 21 may act as a radiator to radiate energy. In addition, the flange 22 may also be made of a metal material, and the flange 22 and the body 21 may be integrally formed. For example, the flange 22 and the body 21 may be formed by using a material such as a metal plate or a metal sheet through a bending or stamping process, so that the accommodation cavity 2 enclosed by the body 21 and the flange 22 is formed as a metal cavity. In this embodiment of this application, the ground post 24 and the feed post 23 may be connected to the flange 22 or the body 21. The feed post 23 and the ground post 24 may be flexibly arranged on the flange 22 or the body 21 based on an actual structure layout of the electronic device, an antenna performance requirement, and an electrostatic discharge requirement. In some embodiments, the body 21 is used as a radiator of the antenna, and the feed post 23 and the ground post 24 may be directly connected to the body 21, so that the body 21 can be directly fed through the feed post 23, and static electricity on the body 21 can be discharged through the ground post 24.

In some embodiments, the body 21 may be made of a plastic material, the metal layer may be a metal sheet, and the metal sheet may be fastened to the surface that is of the body 21 and that is close to the housing 1. The metal layer may be a thin metal sheet with good conductivity, such as a copper sheet, and can be fastened to the body 21 by using a surface mount technology (Surface Mount Technology, SMT). In some embodiments, the metal layer may alternatively be formed on the surface that is of the body 21 and that is close to the housing 1 by using a process such as electroplating. In addition, the flange 22 and the body 21 may alternatively use a same material, so that the body 21 and the flange 22 can be integrally formed, to facilitate processing and manufacturing.

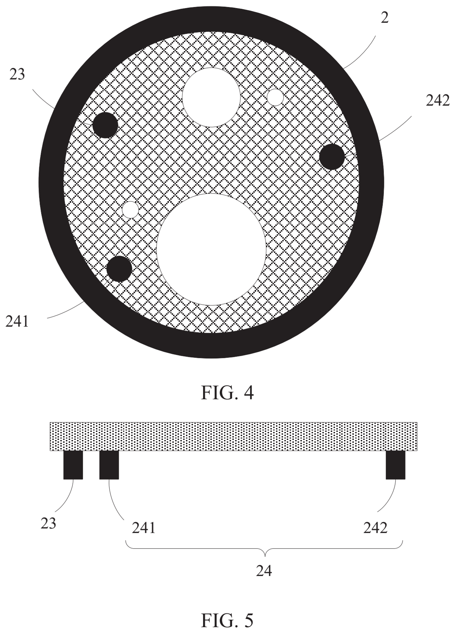

In this embodiment of this application, the metal layer may occupy a large area on the accommodation cavity 2, and electrostatic distribution may vary at different positions of the metal layer. Therefore, static electricity needs to be discharged through the ground post 24 in an area with electrostatic distribution. FIG. 4 is a bottom view of an accommodation cavity 2 according to an embodiment of this application. FIG. 5 is a side view of an accommodation cavity 2 according to an embodiment of this application. Refer to FIG. 4 and FIG. 5. A plurality of ground posts 24 may be disposed and spaced from each other. Two, three, four, or more ground posts 24 may be disposed, and the plurality of ground posts 24 may be distributed at different positions on the metal layer, so that static electricity at different positions on the metal layer can be discharged. In some embodiments, a position of the ground post 24 may be specifically set based on a distribution position of static electricity on the metal layer.

In some embodiments, refer to both FIG. 4 and FIG. 5. The ground post 24 may include a first ground post 241 and a second ground post 242. A distance between the first ground post 241 and the feed post 23 may be less than a distance between the second ground post 242 and the feed post 23. An equivalent inductance of the first ground post 241 is greater than that of the second ground post 242. Although electrostatic discharge can be implemented by disposing the first ground post 241 and the second ground post 242, performance of the antenna is also affected. Therefore, the equivalent inductances of the first ground post 241 and the second ground post 242 need to be configured, to ensure both an electrostatic discharge function and antenna performance. In this embodiment of this application, the first ground post 241 at a position relatively close to the feed post 23 is equivalent to a relatively large inductor, so that a radiation aperture of the antenna can be increased, to meet the electrostatic discharge function, and enable the antenna to obtain excellent radiation performance. The second ground post 242 at a position away from the feed post 23 is equivalent to a relatively small inductor, so that static electricity can be discharged without affecting antenna performance. In this way, both the electrostatic discharge function and antenna performance are considered by configuring the equivalent inductances of the first ground post 241 and the second ground post 242. Therefore, in this embodiment of this application, the equivalent inductance of the first ground post 241 is greater than the equivalent inductance of the second ground post 242, so that static electricity in an area with concentrated static electricity can be effectively discharged to the ground, thereby ensuring normal operation of the camera module 6.

In some embodiments, refer to FIG. 5. One end that is of the first ground post 241 and that is away from the body 21 and/or one end that is of the second ground post 242 and that is away from the body 21 may be connected to the circuit board by using a first matching circuit. A matching circuit connected to the first ground post 241 and a matching circuit connected to the second ground post 242 may be the same or different, and a match manner may be specifically set according to actual grounding and electrostatic discharge requirements.

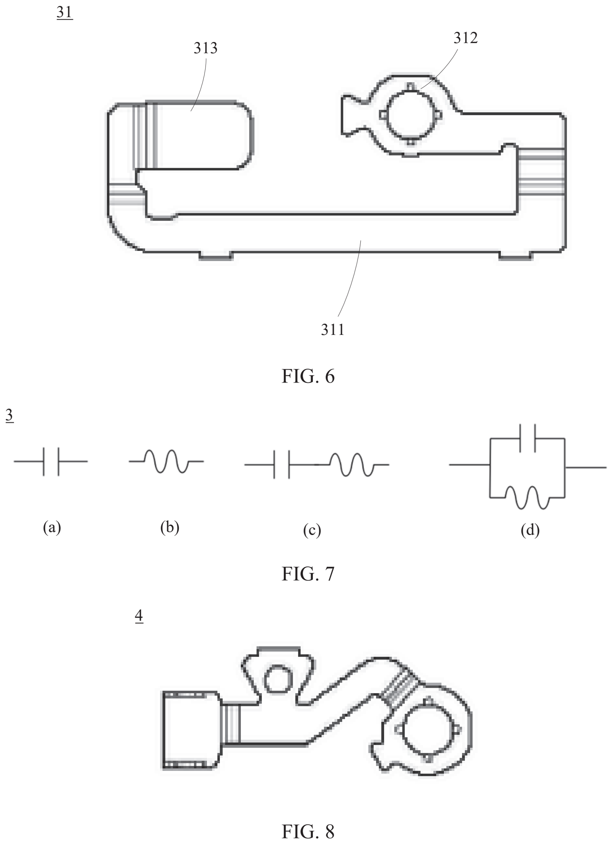

In some embodiments, the electronic device may include the first matching circuit, and the ground post 24 may be connected to the ground terminal by using the first matching circuit. The first matching circuit may include a first metal part 31. For example, FIG. 6 is a top view of a first metal part 31 according to an embodiment of this application. Refer to FIG. 6. The first metal part 31 may be of a metal sheet structure, for example, a copper sheet, and has good conductivity. The first metal part 31 may be an integrally formed metal sheet.

In some embodiments, for ease of description, the first ground post 241 shown in FIG. 5 is used as an example for description. One end of the first metal part 31 may be connected to the first ground post 241, and the other end of the first metal part 31 may be connected to the ground terminal on the circuit board. The first metal part 31 may be equivalent to an inductor element, so that both the electrostatic discharge requirement and antenna performance requirement can be met.

In some embodiments, the electronic device may further include a metal spring (not shown in the figure). The first metal part 31 may be electrically connected to the circuit board by using a metal connector such as a metal spring or a screw, to ensure reliability of electrical connection between the first metal part 31 and the circuit board. Certainly, in some other embodiments, the metal spring may alternatively be replaced with a metal connector such as a screw. The metal connector not only has a connection and fastening function, but also has good conductive performance.

In some embodiments, the first metal part 31 may alternatively be electrically connected to the first ground post 241 by using the metal connector such as the metal spring or the screw, so that reliability of electrical connection between the first metal part 31 and the first ground post 241 can also be ensured. In some embodiments, the first metal part 31 may be grounded without being connected to the circuit board, but may be connected to a grounded metal bracket in an electronic device such as a mobile phone for grounding.

In some embodiments, refer to FIG. 6. The first metal part 31 may include a first connection segment 312, a second connection segment 313, and an extension segment 311. For ease of description, two ends of each of the first connection segment 312 and the second connection segment 313 in a length direction may be respectively defined as a first end and a second end. Two ends of the extension segment 311 are respectively connected to a first end of the first connection segment 312 and a first end of the second connection segment 313, so that the first metal part 31 is C-shaped. A second end of the first connection segment 312 is connected to the first ground post 241, and a second end of the second connection segment 313 is connected to the ground terminal. Neither the second end of the first connection segment 312 nor the second end of the second connection segment 313 is connected to the extension segment 311. The first metal part 31 having this structure may occupy small space, and may have a large physical length between the first ground post 241 and the ground terminal, so that an inductor that meets the antenna performance requirement and the electrostatic discharge requirement can be configured. The first metal part 31 may be an integrally formed structure, so that the first metal part 31 can be easily processed and manufactured. This ensures reliability of the structure, and facilitates assembly and connection.

In some embodiments, the first matching circuit may further include a matching network including elements such as a capacitor and/or an inductor and/or a radio frequency switch. Refer to FIG. 7. Optionally, refer to FIG. 7(a). The matching network may include a capacitor, and the capacitor may be connected in parallel across the ground post 24 and the ground terminal of the circuit board 5. Optionally, refer to FIG. 7(b). The matching network may include an inductor, and the inductor may be connected in series between the ground post 24 and the ground terminal of the circuit board 5. Optionally, the matching network may include a capacitor and an inductor. Refer to FIG. 7(c). The capacitor and the inductor may be connected in series. Refer to FIG. 7(d). The capacitor and the inductor may alternatively be connected in parallel, and are connected between the ground post 24 and the ground terminal of the circuit board 5 in a corresponding series connection or parallel connection manner. Optionally, the matching network may alternatively use a radio frequency switch. The radio frequency switch may include a plurality of branches. Each branch may be configured with a capacitor or an inductor, which can be switched through the switch to connect to a circuit.

The matching network including the foregoing elements such as the capacitor and/or the inductor and/or the radio frequency switch may be integrated on the circuit board 5. In some embodiments, the matching network may be soldered on the circuit board 5. One end of the matching network is connected to the ground terminal of the circuit board 5, and the other end of the matching network may be electrically connected to a corresponding ground post 24 by using a metal connector such as a metal spring or a screw.

As described above, there may be a plurality of ground posts 24, which may be the first ground post 241 and the second ground post 242 described above, or may be other ground posts having grounding and electrostatic discharge functions. Each ground post may be configured with a corresponding capacitor and/or inductor and/or radio frequency switch based on an actual situation. A specific circuit configuration form of the first matching circuit may be designed according to the antenna performance requirement and the electrostatic discharge requirement, so that flexibility of an antenna design may be high.

In some embodiments, the first metal part 31 may alternatively be used in combination with the foregoing matching network. The matching network may be soldered on the circuit board 5. One end of the circuit may be electrically connected to the ground terminal on the circuit board 5, and the other end of the circuit may be electrically connected to the first metal part 31 by using the metal connector such as the metal spring or the screw. It should be noted that, for an electrical connection manner between the first metal part 31 and the first ground post 241, refer to related descriptions in another embodiment of this application. Details are not described herein again.

In addition, for the second ground post 242, a connection manner between the second ground post 242 and the circuit board 5 may be similar to the foregoing connection manner between the first ground post 241 and the circuit board 5. That is, a corresponding first matching circuit may also be configured for the second ground post 242, so that the second ground post 242 is connected to the corresponding matching circuit by using a metal connector such as a metal spring or a screw. In addition, in some embodiments, the second ground post 242 may alternatively be directly and electrically connected to the ground terminal of the circuit board by using a metal spring or a metal connector, or connected to a grounded metal bracket in an electronic device such as a mobile phone, to implement grounding without the need for a corresponding matching circuit.

In addition, for the second ground post 242, a connection manner between the second ground post 242 and the circuit board 5 may be similar to the foregoing connection manner between the first ground post 241 and the circuit board 5. Details are not described herein again.

In some embodiments, the second ground post 242 may be further connected to the ground terminal of the circuit board 5 by using a metal spring, so that connection reliability between the second ground post 242 and the circuit board 5 can be ensured, and effect of electrostatic discharge can be improved through cooperation between the metal spring and the second ground post 242. The metal spring may be fastened to the circuit board 5 by using a process such as soldering.

In some embodiments, when there is one or more ground posts 24, each ground post may alternatively be connected to a corresponding matching circuit according to an actual situation. The matching circuit may be a circuit related to adjusting a radiation characteristic of the antenna. In an embodiment, the matching circuit has a function of impedance matching and/or frequency tuning. In this application, the matching circuit may improve effect of discharging static electricity to the ground through matching impedance.

In some embodiments, the electronic device may further include a second matching circuit, and the feed post 23 may be connected to the feed network by using the second matching circuit. The second matching circuit is a circuit related to adjusting the radiation characteristic of the antenna. In an embodiment, the second matching circuit may have a function similar to that of the first matching circuit. That is, the second matching circuit has the function of impedance matching and/or frequency tuning.

In some embodiments, the second matching circuit may include a second metal part. For example, FIG. 8 is a top view of a second metal part according to an embodiment of this application. Refer to FIG. 8. The second metal part may be a part processed and manufactured independently, and may be specifically of a metal sheet structure, for example, a copper sheet, and has good conductivity. One end of the second metal part is connected to the feed post 23, and the other end of the second metal part is connected to the feed network. For example, the second metal part may be connected to a radio frequency signal line that is in the feed network and that is used to transmit a radio frequency signal of an L5 frequency band. In a direction perpendicular to the thickness direction of the electronic device, the integrally formed metal sheet has a specific length size. In a case in which there is no proper grounding area or feed area at a position directly facing the feed post 23, the metal sheet may be used for transfer. This facilitates more flexible design of the feed post 23, a feed position, and a grounding position, and can meet structural layout requirements of different electronic devices.

In some embodiments, one end of the second metal part may alternatively be electrically connected to the feed post 23 by using a spring sheet or a screw, and the other end of the second metal part may alternatively be electrically connected to the feed network by using a spring sheet or a screw.

In some embodiments, the second metal part may be of an integrally formed structure, so that the second metal part can be easily processed and manufactured. This ensures reliability of the structure, and facilitates assembly and connection.

In some embodiments, the second matching circuit may further include a matching network including elements such as a capacitor and/or an inductor and/or a radio frequency switch. The second matching circuit may have a structure form similar to that of the first matching circuit. Specifically, the capacitor, the inductor, or the radio frequency switch may be configured based on feeding and radiation requirements of the antenna. For example, the capacitor or the inductor may be separately configured. Alternatively, both the capacitor and the inductor may be configured, and are connected in series or in parallel. Alternatively, the radio frequency switch may be used. The radio frequency switch may include a plurality of branches. Each branch may be configured with a capacitor or an inductor, which can be switched through the switch to connect to a circuit. This is not specifically limited in this embodiment, so that flexibility of an antenna design may be high.

In some embodiments, the feed post 23 may be further connected to the feed network of the circuit board 5 by using a metal spring. For example, the feed post 23 may be electrically connected to the metal spring, and the metal spring may be electrically connected to the feed network by using a screw or may be electrically connected to the feed network through soldering.

In some embodiments, the second ground post 242 may alternatively be electrically connected to the ground terminal of the circuit board by using the second matching circuit, or connected to a grounded metal bracket in an electronic device such as a mobile phone, to implement grounding.

In some embodiments, an equivalent inductance of the first matching circuit may be less than 30 nH, and an equivalent inductance of the second matching circuit may be less than 5 nH. When the equivalent inductances of the first matching circuit and the second matching circuit meet the foregoing range, for most electronic devices, static electricity on a metal layer of an accommodation cavity 2 such as a metal camera decorative part can be discharged.

The foregoing descriptions are merely preferred embodiments of this application, and are not intended to limit this application. For a person skilled in the art, this application may have various modifications and variations. Any modification, equivalent replacement, or improvement made without departing from the spirit and principle of this application shall fall within the protection scope of this application.

## Claims

1. An electronic device, comprising:
a housing, wherein the housing is provided with an accommodation cavity, at least a part of the accommodation cavity is provided with a metal layer, a feed post and a ground post are integrally formed in the accommodation cavity, and the feed post and the ground post are electrically connected to the metal layer;
a feed network, wherein the feed network is connected to the feed post, and is configured to feed power to the metal layer through the feed post; and
a circuit board, wherein a ground terminal of the circuit board is electrically connected to the ground post, and is configured to discharge static electricity on the metal layer.

2. The electronic device according to claim 1, further comprising a first matching circuit, wherein the ground post is electrically connected to the ground terminal by using the first matching circuit.

3. The electronic device according to claim 2, wherein the first matching circuit comprises a first metal part, one end of the first metal part is electrically connected to the ground post, and the other end of the first metal part is electrically connected to the ground terminal.

4. The electronic device according to claim 3, wherein the first metal part comprises a first connection segment, a second connection segment, and an extension segment, two ends of the extension segment are respectively connected to a first end of the first connection segment and a first end of the second connection segment so that the first metal part is C-shaped, a second end of the first connection segment is connected to the ground post, and a second end of the second connection segment is connected to the ground terminal.

5. The electronic device according to claim 2, wherein the first matching circuit comprises a capacitor and/or an inductor and/or a radio frequency switch.

6. The electronic device according to any one of claims 2 to 5, further comprising a second matching circuit, wherein the feed post is connected to the feed network by using the second matching circuit.

7. The electronic device according to claim 6, wherein the second matching circuit comprises a second metal part, one end of the second metal part is electrically connected to the feed post, and the other end of the second metal part is electrically connected to the feed network.

8. The electronic device according to claim 6, wherein the second matching circuit comprises a capacitor and/or an inductor and/or a radio frequency switch.

9. The electronic device according to any one of claims 1 to 8, wherein a plurality of ground posts may be disposed and spaced from each other.

10. The electronic device according to any one of claims 6 to 8, wherein the ground post comprises a first ground post and a second ground post, a distance between the first ground post and the feed post is less than a distance between the second ground post and the feed post, and an equivalent inductance of the first ground post is greater than an equivalent inductance of the second ground post.

11. The electronic device according to claim 10, wherein an equivalent inductance of the first matching circuit is less than 30 nH, and an equivalent inductance of the second matching circuit is less than 5 nH.

12. The electronic device according to claim 10, wherein that the end of the first metal part is electrically connected to the ground post comprises:
the end of the first metal part is electrically connected to the first ground post.

13. The electronic device according to claim 10, further comprising a metal spring, wherein the second ground post is connected to the ground terminal by using the metal spring.

14. The electronic device according to any one of claims 1 to 13, wherein the accommodation cavity comprises a body and a flange, and the flange is circumferentially around and connected to an edge of the body;
the flange is connected to the housing, and the body protrudes from a surface that is of the housing and that is away from the accommodation cavity; and
the metal layer is disposed on a surface that is of the body and that is close to the housing.

15. The electronic device according to claim 14, wherein the body is made of a metal material, and the metal layer is the surface that is of the body and that is close to the housing.

16. The electronic device according to claim 14, wherein the body is made of a plastic material, the metal layer is a metal sheet, and the metal sheet is fastened to the surface that is of the body and that is close to the housing.

17. The electronic device according to claim 14, wherein the accommodation cavity is a metal camera decorative part, and the metal camera decorative part is provided with a camera opening.

18. The electronic device according to any one of claims 1 to 17, wherein a center frequency of a radio frequency signal fed by the feed network to the metal layer through the feed post is 1.17 GHz.
